(19) Europäisches Patentamt
European Patent Office
Office européen des brevets

(11) EP 4 554 092 A1

(12) EUROPEAN PATENT APPLICATION

(43) Date of publication:
14.05.2025 Bulletin 2025/20

(21) Application number: 23306948.3

(22) Date of filing: 10.11.2023

(51) International Patent Classification (IPC):
H03K 17/0812 (2006.01)    H02M 1/32 (2007.01)
H02M 7/5387 (2007.01)    H03K 17/18 (2006.01)

(52) Cooperative Patent Classification (CPC):
H03K 17/08128; H02M 1/08; H02M 7/5387;
H03K 17/08122; H03K 17/18; H03K 17/689;
H02M 1/32; H02M 1/38

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicants:
• Mitsubishi Electric R&D Centre Europe B.V.
1119 NS  Schiphol Rijk Amsterdam (NL)
Designated Contracting States:
FR
• MITSUBISHI ELECTRIC CORPORATION
Chiyoda-ku
Tokyo 100-8310 (JP)
Designated Contracting States:
AL AT BE BG CH CY CZ DE DK EE ES FI GB GR
HR HU IE IS IT LI LT LU LV MC ME MK MT NL NO
PL PT RO RS SE SI SK SM TR

(72) Inventors:
• Lefevre, Guillaume
35708 RENNES CEDEX 7 (FR)
• Le Leslé, Johan
35708 RENNES CEDEX 7 (FR)

(74) Representative: Plasseraud IP
104 Rue de Richelieu
CS92104
75080 Paris Cedex 02 (FR)

(54) **CURRENT INTERRUPTION PROTECTION FOR CURRENT SOURCE CONVERTERS USING GATE CURRENT MIRRORS**

(57)    Control circuit for a current source converter having a current generator comprising an inductance (2) and having two or more half bridges each half bridge having an upper leg provided with an upper switching device (11, 13) and a lower leg provided with a lower switching device (12, 14), said upper legs switching devices and said lower legs switching devices being controlled by a controller (40) to provide an overlap between an upper leg turning off and an upper leg turning on switching device and to provide an overlap between a lower leg turning on switching device and a lower leg turning off switching device through gate pull up and gate pull down pulse signals to gate drivers buffers (6) of said switching devices, where said gate driver circuit comprises:
- for each switching device (11, 12, 13, 14) a gate current mirroring circuit (5) on a sink branch of the gate driver buffer (6) of such switching device (11, 12, 13, 14) to provide a gate pull down detection signal ($I_m$) from a turning OFF switching device,
- for each switching device (11, 12, 13, 14) a gate command connection path to provide a gate command signal (G),
at least one logic circuit combining a gate command signal (G) of a first upper or lower leg switching device and a gate pull down signal of a respectively second upper or lower leg switching device to provide a first protection trigger signal (Pr), when said gate command signal of said first upper or lower leg switching device and said gate pull down detection signal of said respective second upper or lower leg switching device correspond to both said first and second upper leg switching devices or both said first and second lower leg switching devices being OFF; converter having such a control circuit.

FIG. 2

# Description

## Field of the invention

The present disclosure concerns current source power converters comprising at least two half-bridges with upper and lower switching devices and more precisely concerns the reduction of the risk of current interruption when switching from one upper switching device to another upper switching device or switching from one lower switching device to another lower switching device.

## Background

Current source converters (CSC) are used for different applications, such as HVDC, motor drive or power factor correctors. The main limitation of such converters mainly was the use of bulky input inductances and power modules designed for conventional switching cells. However, the growing emergence of wide bandgap devices, e.g. Silicone Carbide and/or Gallium Nitride, with lower conductive and switching losses opened up new perspectives for current fed converters design by reducing their size and improving their efficiency.

In a current fed power converter composed of at least two half bridges, the switches of the different half bridges are controlled in a complementary way (conducting to blocking and blocking to conducting). Between these transitions, overlapping (both switches ON) between upper switching devices and between lower switching devices is used. The main reason of the overlapping is due to the nature of the input source which is an inductive source that resist current changes and may cause overvoltage pulses in case of abrupt current changes. A cause of DC link current interruption can be due to multiple factors, including wrong control signal of a switching device, a faulty device failed in open circuit or a failed gate driver. In consequence, an open current path for the DC current can lead to tremendous damages. A current interruption in current fed converter induces a fast increase in the voltage across the semiconductor devices, higher than the breakdown voltage, causing the destruction of the power converter. In such a case, the power devices may enter in an avalanche mode dissipating the energy stored in the inductance but cannot withstand such high voltage and high current conditions during too much time.

While such overlapping is necessary to avoid voltage peaks, a reduction of the overlapping time is beneficial for the overall converter operation. In fact, a too high overlapping time would lead to a high Total Harmonic Distortion (THD) of the output current. Some software solutions can be implemented in the control loop to mitigate such side effects. In addition, the reduction of the overlapping time could reduce the losses in case of a CSC having current bidirectionality feature where the control of the two devices placed in series depends on the overlapping time, the longer the overlapping time the longer is the conduction of one of the body diodes, thus the conduction losses increase because of the high forward voltage. The reduction of the overlapping time also creates a need to prevent an open circuit situation that could occur due to timing mismatches between the commands of the gate driver of the closing switching device and the opening switching device.

## Summary of the invention

In view of the situation, the method and device proposed in the present disclosure provides a way to prevent an open circuit situation downstream of an inductance of a current generator in a current fed converter during commutation between upper switching devices of two or more half bridges of such converter or between lower switching devices of said two or more half bridges of such converter through detecting that an upper or lower current conducting switching device is turned off prior to the turning on of another respectively upper or lower switching device and triggering a protection circuit that creates a conductive path at the poles of the current generator. This prevents overvoltage peaks due to a failure such as a false control signal or a faulty gate driver.

More precisely the present disclosure proposes a control circuit for a current source converter having a current generator comprising an inductance and having two or more half bridges each half bridge having an upper leg provided with an upper switching device and a lower leg provided with a lower switching device, said upper legs switching devices and said lower legs switching devices being controlled by a controller to provide an overlap between an upper leg turning off and an upper leg turning on switching device and to provide an overlap between a lower leg turning on switching device and a lower leg turning off switching device through gate pull up and gate pull down pulse signals to gate drivers buffers of said switching devices, wherein said gate driver circuit comprises:

- for each switching device a gate current mirroring circuit on a sink branch of the gate driver buffer of such switching device to provide a gate pull down detection signal from a turning OFF switching device,
- for each switching device a gate command connection path to provide a gate command signal,

at least one logic circuit combining a gate command signal of a first upper or lower leg switching device and a gate pull down signal of a respectively second upper or lower leg switching device to provide a first protection trigger signal, when said gate command signal of said first upper or lower leg switching device and said gate pull down detection signal of said respective second upper or lower leg switching device correspond to both said first and second upper leg switching devices or both said first and second lower leg switching devices being OFF.

The controller controls switching of the switching devices through gate pre-drivers each having a gate buffer, said controller providing, through said gate pre-drivers, gate pull up and gate pull down pulse signals to the gates drivers buffers. The controller is configured to create an overlapping time during switching transitions between switching devices of a first and a second half-bridge, wherein said gate buffers of said gate drivers are each provided with a current mirroring circuit on their sink branch and a detection circuit configured for triggering a protection circuit comprising a protection switch at poles of said current source converter. In case a command signal or a driver buffer does not provide turning on of a switch while a corresponding switch is turning off, the control circuit of the present disclosure creates a current path at the poles of the current generator to avoid overvoltage, such overvoltage being caused by energy stored in the inductance of the current generator.

In a particular realization mode, said gate command signal of a first upper or lower leg switching device may be inverted and the inverted gate command signal combined with said gate pull down signal of said respective second upper or lower leg switching device in an AND gate to provide said protection trigger signal.

Preferably, the control circuit may comprise OR gates to combine the protection trigger signals of the gate drivers of the upper switch devices and of the gate drivers of the lower switch devices of the current source converter.

The gate command signal of each switching device may be taken after a pre driver providing a galvanic isolation between the controller and the gate driver buffer of said switching device.

Said gate current mirroring circuit of each switching device may provide said gate pull down detection signal from a turning OFF switching device through a galvanic isolation device.

The present disclosure also concerns a current source converter comprising a control circuit according to any one of the preceding claims.

The use of gate mirroring circuits provides an accurate view of gate command signals without causing perturbations on the gate commands.

The gate driver buffers provide a first galvanic isolation between said controller and said gate driver buffers.

## Brief description of the drawings

A detailed description of exemplary embodiments disclosed will be discussed hereunder in reference to the attached drawings where:

Figure 1 is a schematic view of a traditional single phase current source inverter;
Figure 2 is a schematic view of an example of detection circuit according to an embodiment of the present disclosure;
Figures 3 shows a complete control circuit of the present disclosure;
Figure 4 shows a schematic view of a traditional three phases current source inverter;

## Detailed description of embodiments of the invention

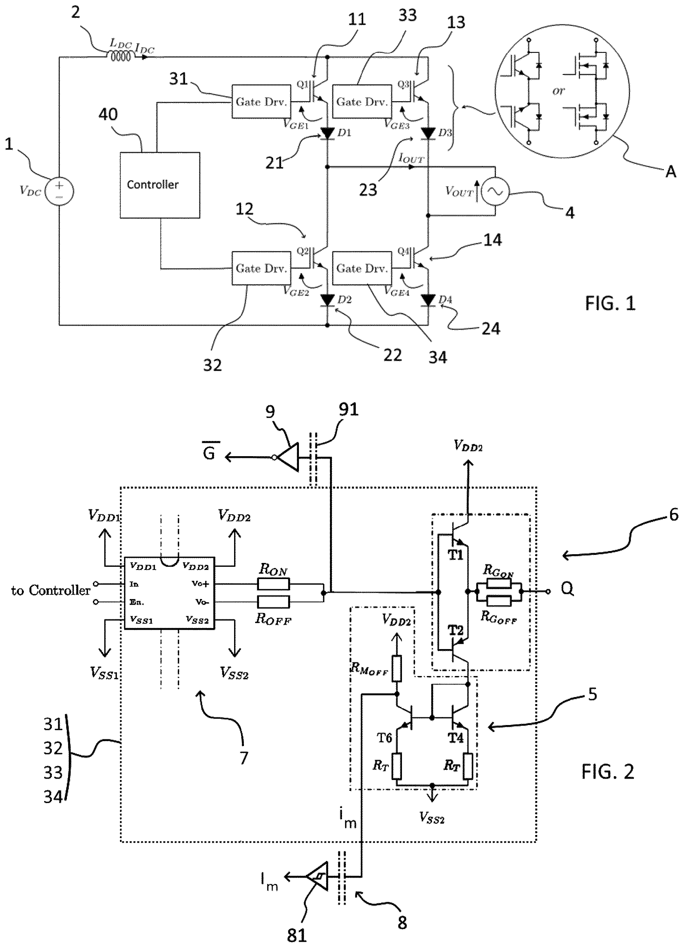

Figure 1 is a schematic view of a DC/AC current source converter also called inverter. Such converter comprises a DC source 1 an inductance 2 and two half bridges. A first half-bridge comprises first upper leg switch device 11 with IGBT Q1 and a diode 21 and first lower leg switch device 12 with IGBT Q2 and diode 22. A second half-bridge comprises second upper leg switch device 13 with IGBT Q3 and a diode 23 and second lower leg switch device 14 with IGBT Q4 and diode 24. The IGBT+ diode design shown may be replaced with serial opposite polarity IGBTs with reverse freewheeling diodes or serial reverse polarity MOSFET having inherent body diode or with additional freewheeling diodes such as in circle A.

The half-bridges of the current source converter are connected to an alternating voltage and current load 4.

The switches are controlled through gate drivers, a first gate driver 31 for the first half-bridge first upper leg switch device 11, a second gate driver 32 for the first half-bridge first lower switch device 12, a third gate driver 33 for the second upper leg switch device 13 of the second half bridge and gate driver 34 for the second lower leg switch device 14 of the second half-bridge.

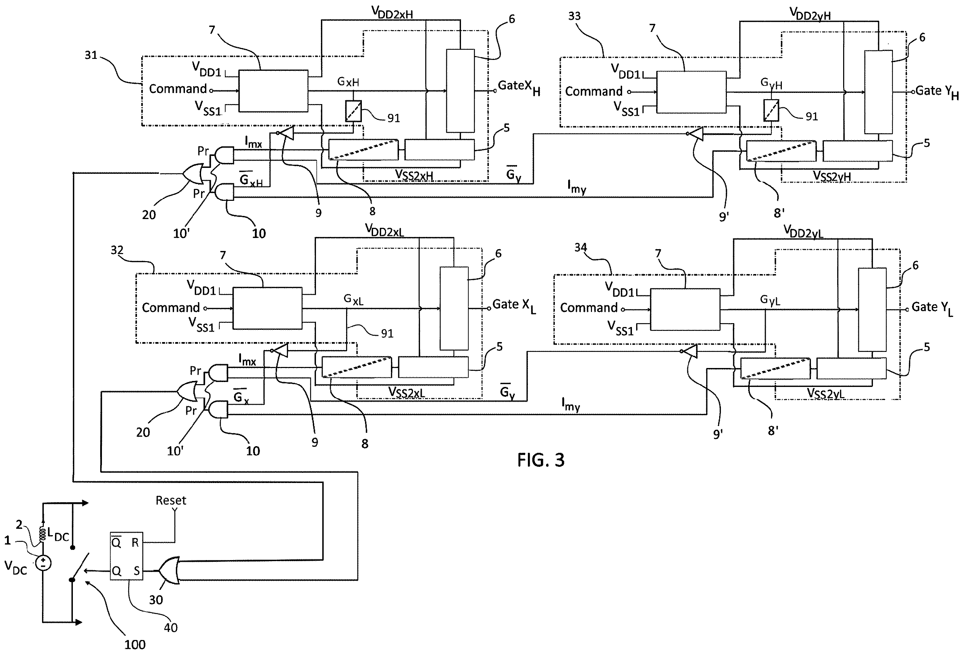

Starting from such basic schematics, the present disclosure concerns a driver circuit that aims at avoiding open circuit situations, e.g. in case an overlap does not occur during switching transitions between upper legs switching devices 11, 13 or during switching transitions between lower legs switching devices 12, 14 or in case a switch device does not turn on due to a faulty gate driver. Such circuit shown in figure 2 uses a sink current mirror circuit 5 to sense the gate current on a sink side of a gate buffer 6 of a first upper or lower switching device. The detailed circuit of figure 2 shows a gate driver comprising a pre-driver 7 which provides a galvanic isolation between the controller circuitry having a first supply $V_{DD1}$, $V_{SS1}$ and a switch device circuitry comprising gate buffer 6 and having a second supply $V_{DD2}$, $V_{SS2}$. The gate buffer comprises push pull transistors T1 and T2 and the sink current mirror circuit 5 is connected between the collector of T2 and the negative voltage $V_{SS2}$. In the sink current mirror circuit 5, the transistor T4 is in a diode configuration as its base and collector electrodes are shorted. The current flowing through T4's collector, being the gate current during turn-off, generates a corresponding base-emitter voltage (VBE) being the same VBE voltage for the transistor T6. Therefore, the current flowing through T6 will be the image of the gate current. The mirror resistor ($R_{MOFF}$) should be less or equal to the overall gate resistance ($R_{GTot}$) to obtain a current with the same amplitude. In the case of $R_{MOFF} > R_{GTot}$ the maximal current is capped and equal to $\frac{(V_{DD} - V_{SS} - VCE_{Sat})}{R_{MOFF}}$. Then, the image $i_m$ of the mirrored current after being conditioned and passed through a galvanic isolation 8 is transformed in a logic signal $I_m$ which is as shown in figure 3 combined through a AND gate with the inverted gate command signal $\overline{G}$ of a second respectively upper or lower switch device with which a commutation with overlap is to be done.

The logic signal $I_m$ is in the described example a logic ONE signal when the switching device passes from a current conducting state (ON state) to a current blocking state (OFF state).

Also shown on figure 2 is a detection line providing a signal representative of the command signal from the controller at the mixed output of the pre-driver 7 after resistors $R_{ON}$ and $R_{OFF}$. In the example this signal which is already a logic signal goes through a galvanic isolation 91 and is inverted in inverter 9 to provide the inverted gate command signal $\overline{G}$ of the corresponding switching device which is a logic ONE when the gate command signal G is low which corresponds to a switching device in an OFF state.

As shown on figure 3 the inverted gate command signal $\overline{G}_x$ of a first upper switch device X is added through a AND gate 10 with the gate current detection signal $I_{my}$ of a second upper switch device Y and the inverted gate command signal $\overline{G}_y$ of the second upper switch device Y is added through a AND gate 10' with the gate current detection signal $I_{mx}$ of the first upper switch device X, the output signals of the two AND gates being input to an OR gate 20.

The same applies to the lower switches inverted gate command signal $\overline{G}_x$ and gate current detection signal which are combined in AND gates 10, 10' which have their outputs combined in a further OR gate 20. The signals output from the OR gate for the upper switches and the signal output from the OR gate for the lower switches are in turn combined in a further OR gate 30 to turn on a protection switch 100 which provides a short circuit at the poles of the current generator comprising the source 1 and the inductor 2 when a switch which should turn ON remains OFF either in the upper legs or in the lower legs. Since this circuit concerns a fault detection, a latch gate is positioned between the output of the OR gate 30 and the protection switch 100, to keep the protection active until a reset coming from the controller is sent to the latch gate.

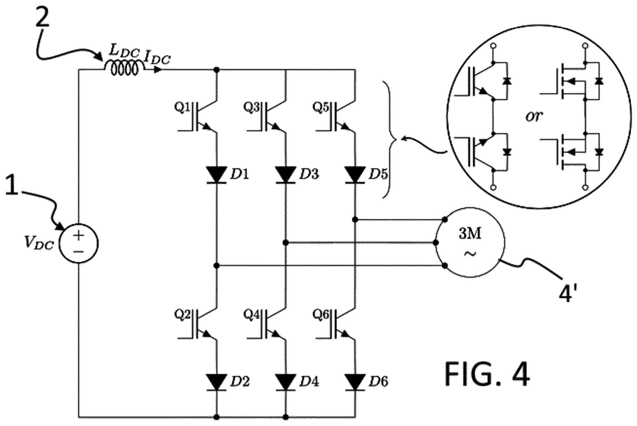

The circuitry of figure 3 is used for upper switch devices and lower switch devices and can be used for upper and lower switches devices of inverters having two half bridges but also three half bridges and a three-phase load 4' as in figure 4 or more.

Back to figure 2, usually, the transistors T4 and T6 are matched transistors, having the same gain (b) and sharing the same package. The transistors selected to design the current mirrors must have the same, or close, characteristics as the ones in the buffer (current capability, gain-bandwidth product). The current mirror circuits are not limited to BJT components.

The mirrored current signal taken at the bottom of resistor $R_{MOFF}$ is injected into the detection circuit through a galvanic isolation device 8 and such insolation device may be, depending on the situation, an optocoupler, a current transformer, a voltage transformer or even a digital isolator since the voltages $V_{DD2xH}$, $V_{SS2xH}$ of the first upper leg of the first half-bridge switch element having gate $X_H$, the voltages $V_{DD2yH}$, $V_{SS2yH}$ of the first upper leg of the second half-bridge switch element having gate $Y_H$, the voltages $V_{DD2xL}$, $V_{SS2xL}$ of the first lower leg of the first half-bridge switch element having gate $X_L$ and the voltages $V_{DD2yL}$, $V_{SS2yL}$ of the second lower leg of the second half-bridge switch element having gate $Y_L$ are not the same and also different from the logic voltages needed to control the protection device 100.

The signals $i_m$ transferred through the isolation devices 8, 8' may be amplified or triggered in gate 81 having hysteresis to become a logic signal.

The invention is not limited to the above description and e.g. realization of logical circuits may also be done with bipolar transistors or MOS transistors, the positive logic described may be replaced by inverted logic where the gate command signal G is combined with the inverted gate pull down detection signal and as said before the control circuit may be adapted to a three phase output current source converter as per figure 4 with the use of adapted logic circuits such as three input AND gates and OR gates to combine the gate command signals and gate pull down detection signals of three half-bridges. Also, the present disclosure may be applied to DC/AC converters but also to AC/DC converters, the source and load being reversed.

In addition, the present invention may be combined with a circuit designed to reduce the overlap times in the transitions between the current source converter upper legs switches or lower legs switches, such circuit using a source current mirror circuit similar to the sink current mirror depicted.

**Claims**

1. Control circuit for a current source converter having a current generator comprising an inductance (2) and having two or more half bridges each half bridge having an upper leg provided with an upper switching device (11, 13) and a lower leg provided with a lower switching device (12, 14), said upper legs switching devices and said lower legs switching devices being controlled by a controller (40) to provide an overlap between an upper leg turning off and an upper leg turning on switching device and to provide an overlap between a lower leg turning on switching device and a lower leg turning off switching device through gate pull up and gate pull down pulse signals to gate drivers buffers (6) of said switching devices, **characterized in that** said gate driver circuit comprises:

- for each switching device (11, 12, 13, 14) a gate current mirroring circuit (5) on a sink branch of the gate driver buffer (6) of such switching device (11, 12, 13, 14) to provide a gate pull down detection signal ($I_m$) from a turning OFF switching device,
- for each switching device (11, 12, 13, 14) a gate command connection path to provide a gate command signal (G),

at least one logic circuit combining a gate command signal (G) of a first upper or lower leg switching device and a gate pull down signal of a respectively second upper or lower leg switching device to provide a first protection trigger signal (Pr), when said gate command signal of said first upper or lower leg switching device and said gate pull down detection signal of said respective second upper or lower leg switching device correspond to both said first and second upper leg switching devices or both said first and second lower leg switching devices being OFF.

2. Control circuit according to claim 1 wherein said gate command signal of a first upper or lower leg switching device is inverted (9) and the inverted gate command signal ($\overline{G}$) is combined with said gate pull down signal ($I_m$) of said respective second upper or lower leg switching device in an AND gate to provide said protection trigger signal (Pr).

3. Control circuit according to claim 1 or 2 comprising OR gates (20, 30) to combine the protection trigger signals of the gate drivers of the upper switch devices and of the gate drivers of the lower switch devices of the current source converter.

4. Control circuit according to claim 1, 2 or 3 wherein the gate command signal of each switching device is taken after a pre driver providing a galvanic isolation between the controller and the gate driver buffer of said switching device.

5. Control circuit according to any one of the preceding claims wherein said gate current mirroring circuit of each switching device provide said gate pull down detection signal from a turning OFF switching device through a galvanic isolation device (8).

6. Current source converter comprising a control circuit according to any one of the preceding claims.

7. Method for protecting a current source converter from open circuits in the current source path during switching transitions between upper legs half bridges each half bridge having an upper leg provided with an upper switching device (11, 13) and a lower leg provided with a lower switching device (12, 14), said upper legs switching devices and said lower legs switching devices being controlled by a controller (40) to provide an overlap between an upper leg turning off and an upper leg turning on switching device and to provide an overlap between a lower leg turning on switching device and a lower leg turning off switching device through gate pull up and gate pull down pulse signals to gate drivers buffers (6) of said switching devices, **characterized in that** said gate driver circuit comprises:

- for each switching device (11, 12, 13, 14) a gate current mirroring circuit (5) on a sink branch of the gate driver buffer (6) of such switching device (11, 12, 13, 14) to provide a gate pull down detection signal ($I_m$) from a turning OFF switching device,
- for each switching device (11, 12, 13, 14) a gate command connection path to provide a gate command signal (G),
said method comprising combining a gate command signal (G) of a first upper or lower leg switching device and a gate pull down signal of a respectively second upper or lower leg switching device to provide a first protection trigger signal (Pr), when said gate command signal of said first upper or lower leg switching device and said gate pull down detection signal of said respective second upper or lower leg switching device correspond to both said first and second upper leg switching devices or both said first and second lower leg switching devices being OFF and,
using said protection trigger signal (Pr) to switch on a load between the poles of the converter.

FIG. 1

FIG. 2

FIG. 3

EP 4 554 092 A1

FIG. 4

# EUROPEAN SEARCH REPORT

Application Number

EP 23 30 6948

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 152 542 A1 (MITSUBISHI ELECTRIC R&D CT EUROPE BV [NL] ET AL.) 22 March 2023 (2023-03-22) * claim 1; figures 1, 2, 3A, 3B * | 1-7 | INV. H03K17/0812 H02M1/32 H02M7/5387 H03K17/18 |
| A | AKBAR FAZAL ET AL: "CSI7: Novel Three-Phase Current-Source Inverter With Improved Reliability", IEEE TRANSACTIONS ON POWER ELECTRONICS, INSTITUTE OF ELECTRICAL AND ELECTRONICS ENGINEERS, USA, vol. 36, no. 8, 20 January 2021 (2021-01-20), pages 9170-9182, XP011853898, ISSN: 0885-8993, DOI: 10.1109/TPEL.2021.3053132 [retrieved on 2021-05-11] * paragraph [0IV.]; figures 2, 4 * | 1-7 | |
| A | CN 116 505 747 A (UNIV SHANDONG SCIENCE & TECH) 28 July 2023 (2023-07-28) * the whole document * | 1-7 | TECHNICAL FIELDS SEARCHED (IPC) H03K H02M |

The present search report has been drawn up for all claims

| Place of search | Date of completion of the search | Examiner |
|---|---|---|
| The Hague | 28 March 2024 | Fermentel, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 30 6948

This annex lists the patent family members relating to the patent documents cited in the above-mentioned European search report.
The members are as contained in the European Patent Office EDP file on
The European Patent Office is in no way liable for these particulars which are merely given for the purpose of information.

28-03-2024

| Patent document cited in search report | | Publication date | Patent family member(s) | | Publication date |
|---|---|---|---|---|---|
| EP 4152542 | A1 | 22-03-2023 | EP | 4152542 A1 | 22-03-2023 |
| | | | WO | 2023042417 A1 | 23-03-2023 |
| CN 116505747 | A | 28-07-2023 | NONE | | |

EPO FORM P0459